# EUROPEAN PATENT APPLICATION

(11) **EP 4 435 843 A1**
(43) Date of publication of application: **25.09.2024**
(21) Application number: 23163364.5
(22) Date of filing: 22.03.2023
(51) Int. Cl.: H01L 21/822, H01L 27/06, H01L 27/092, H01L 29/06, H01L 29/775

(54) **A CFET CELL AND A METHOD OF FABRICATING A CFET CELL**

(71) Applicant: Imec VZW, 3001 Leuven (BE)
(72) Inventor: Hiblot, Gaspard, 3001 Leuven (BE); Mirabelli, Gioele, 3001 Leuven (BE)
(74) Representative: Roth, Sebastian

(57) **Abstract**

The disclosure relates to a complementary field effect transistor (CFET) cell (10). The CFET cell (10) comprises: a first transistor structure (11) arranged in a first tier of the CFET cell (10); a second transistor structure (12) arranged in a second tier of the CFET cell (10) above the first tier; a set of top signal routing lines (15) formed in a first metal layer above the second tier and connected to the first and the second transistor structure (11, 12) from above; and at least one bottom signal routing line (16) formed in a second metal layer below the first tier and connected to the first transistor structure (11) from below. The disclosure relates to a method of fabricating a CFET cell (10).

## Description

### TECHNICAL FIELD

The present disclosure relates to complementary field effect transistor (CFET) devices. The disclosure is concerned with a routability of stacked transistor structures in a CFET cell. The disclosure presents a CFET cell with a specifically designed signal routing structure, a CFET device that includes at least two of these CFET cells, as well as a method of fabricating such a CFET cell.

### BACKGROUND

In a CFET device, different transistor structures, particularly NMOS and PMOS transistor structures, may be stacked on top of each other. Compared, for example, to a nanosheet device, which comprises NMOS and PMOS transistor structures arranged side by side with a spacing in between them, the stacking of the transistor structures enables increasing an effective channel width.

A CFET device may include one or more CFET (unit) cells. An exemplary implementation of a CFET cell may comprise two NMOS transistor structures and two PMOS transistor structures which are processed in a stacked manner.

An issue in an exemplary conventional CFET device is related to the connections of the transistor structures, especially, their connections to the power rails and to the signal routing lines.

In particular, it is difficult to connect the bottom device contacts in CFET, because they are shadowed by the top device in the center of the standard cell, thus they can only be accessed at the edges of the standard cell. In addition, if two parallel bottom contacts need to be connected, tall vias (e.g. high aspect vias) are needed to connect them from the top metal level whose orientation is perpendicular to the bottom contacts.

This situation becomes even worse when using a top power rail to provide power to the top device, as the top power rail occupies one edge of the standard cell. As a result, only the single edge opposing the top power rail can be used to access the bottom device contacts, hence it becomes impossible to route some types of standard cells.

### SUMMARY

Thus, it is an objective to provide an improved CFET cell and an improved method of fabricating a CFET cell. In particular, the above-mentioned disadvantages should be avoided.

The objective is achieved by the embodiments provided in the enclosed independent claims. Advantageous implementations of the embodiments of the invention are further defined in the dependent claims.

A first aspect of this disclosure provides a CFET cell, comprising: a first transistor structure arranged in a first tier of the CFET cell; a second transistor structure arranged in a second tier of the CFET cell above the first tier; a set of top signal routing lines formed in a first metal layer above the second tier and connected to the first and the second transistor structure from above; and at least one bottom signal routing line formed in a second metal layer below the first tier and connected to the first transistor structure from below.

This achieves the advantage that a more compact CFET cell design is provided in which the bottom transistor structure can be contacted via a dedicated bottom signal routing line. For example, the bottom signal routing line can be "tucked" under a gate extension of the CFET cell and thus does not lead to an enlargement of the CFET cell, while more complex (bi-directional) side routing structures would need to run around the gate extension, causing an extra area penalty.

Furthermore, the CFET cell can be easier to fabricate compared to CFET cells with more complex, e.g., two- or three-dimensional side routing structures. This is, in particular, due to a simpler alignment of a one-dimensional signal routing line during fabrication as compared to more complex (side) routing structures.

One or more transistor structures arranged in the first tier and one or more transistor structures arranged in the second tier may result in stacked transistor structures of the CFET cell. However, two particular transistor structures of the CFET cell - one in the first tier and the other one in the second tier - do not have to be arranged directly above each other (with respect to a stacking direction of the CFET cell, typically the "vertical" direction in this disclosure), but may also be arranged indirectly above each other, which means that they may be offset in a "horizontal" direction, which is perpendicular to the "vertical" or stacking direction. The CFET cell may comprise further transistor structures or other elements, which could respectively be directly above or beneath the first and second transistor structure.

Notably, in this disclosure the terms "below" and "above", "bottom" and "top", or similar terms are to be interpreted relative to each other. In particular, these terms describe opposite sides of the CFET cell, or opposite side of any element of the CFET cell. The terms may describe a relationship of elements (e.g., transistor structures, signal routing lines, power rails, etc.) of the CFET cell along the direction of stacking of the tiers. The stacking direction may thus align with the arrangement of the two tiers (or even more than two tiers) of the CFET cell. That is, the two or more tiers, which are arranged above each other, are arranged one after the other along a certain direction (the stacking direction). The relative terms could also be swapped. For instance, in the CFET cell of the first aspect, the set of top signal routing lines is placed at the top side of the CFET cell (above the second tier), while the at least one bottom signal routing line is placed at the bottom side of the CFET cell (below the first tier). However, the set of top signal routing lines could also be considered being at the bottom side of the CFET cell (below the first tier), and the bottom signal routing line(s) could be considered being at the top side of the stacked CFET cell (above the second tier).

A transistor structure in this disclosure may be or may comprise a transistor, for example a field effect transistor (FET), or may be or may comprise a more complex semiconductor-based structure, which functions like a transistor. For instance, the semiconductor-based structure may be a nanosheet structure, a fin structure, or a forksheet structure, for example, provided with a gate partly wrapping around or fully wrapping around channel portions. The latter may be for instance a gate-all-around structure. The transistor structures of the CFET cell of the first aspect may be NMOS and PMOS transistor structures. For instance, the first transistor structure may be an NMOS transistor structure and the second transistor structure a PMOS transistor structure, or vice versa.

A set of elements in this disclosure may comprise one or more of the elements. For instance, the set of top signal routing lines may comprise one or more top signal routing lines, for example, three or four top signal routing lines.

The top signal routing lines may be formed in a metal intermediate (Mint) layer, i.e., the first metal layer may be a Mint layer. The Mint layer may be a horizontal metal layer in the CFET cell. The first metal layer of the top signal routing lines may be independent of and/or different from the second metal layer of the bottom signal routing line(s).

The bottom signal routing line can be a buried horizontal local interconnect which is, e.g., introduced in the empty space below the bottom (first) transistor structure, for instance, next to a back-side contact of the first transistor structure. The bottom signal routing line can provide horizontal routability to the first transistor structure polarity, e.g., to connect N-junctions and/or P-junctions.

In an implementation, the bottom signal routing line is a one-dimensional line structure, and/or is configured to route signals along one spatial direction.

For example, the bottom signal routing line being one-dimensional means that it extends along one spatial direction and is spatially confined in all other spatial directions. This achieves the advantage that it is easier to align to other structures of the CFET cell during fabrication, especially during lithographic fabrication steps.

In an implementation, the bottom signal routing line extends along a direction which is perpendicular to a gate of the first transistor structure and/or to a gate of the second transistor structure.

For example, the bottom signal routing line runs parallel to one or more channels (e.g., parallel to the fin direction) of the first transistor structure.

In an implementation, the bottom signal routing line is connected to one or more metal zero (Mo) layer contacts of the first transistor structure, wherein each Mo layer contact is connected to a source or a drain of the first transistor structure.

For example, the connections of the bottom signal routing line to the Mo layer contacts can be established by short vertical contact sections, such as vias.

In an implementation, the CFET cell further comprises a first power rail arranged below the first tier and connected to the first transistor structure from below. For example, the at least one bottom signal routing line is arranged above the first power rail and below the first transistor.

In an implementation, the CFET cell further comprises a second power rail formed in a third metal layer and connected to the second transistor structure from a first side.

The first and the second power rails may be rails for VDD and VSS. For instance, the first power rail may be configured to supply VDD (a supply voltage), i.e., is a VDD rail, and the second power rail may be configured to supply VSS (a ground voltage or negative voltage), i.e., is a VSS rail. VDD and VSS can be swapped, if NMOS and PMOS are swapped as well for the first transistor structure and the second transistor structure.

The second power rail being connected to the second transistor structure from the first side may simplify connections of the second transistor structure to the second power rail, without the need for any deep etch processing and/or the use of high aspect-ratio vias. This also allows leveraging the first power rail as a back-side power rail. The CFET cell of the first aspect is further scalable in track height, without penalizing routing resources and active area.

For example, a part of the second power rail is arranged in the second tier to the first side of the second transistor structure; and/or a part of the second power rail is arranged in the first tier to the first side of the first transistor structure.

In an implementation, the second power rail extends vertically to a bottom side or to a top side of the CFET cell.

In this case, for instance, the CFET cell typically comprises one bottom signal routing line which is arranged on a side opposite to the second power rail.

In an implementation, the top signal routing lines of the set of top signal routing lines are arranged side by side, and a part of the second power rail is arranged to the first side of the set of top signal routing lines.

For example, the second power rail has a width that is equal to or larger than two times a critical dimension of the first metal layer.

A second aspect of this disclosure provides a device comprising two CFET cells according to the first aspect of this disclosure, wherein the two CFET cells are arranged side by side.

For example, the second power rail of the two CFET cells is the same power rail, which is arranged between the transistor structures of one CFET cell and the transistor structures of the other CFET cell.

A third aspect of this disclosure provides a method of fabricating a complementary field effect transistor (CFET) cell, comprising the steps of: forming a first transistor structure in a first tier of the CFET cell; forming a second transistor structure in a second tier of the CFET cell above the first tier; processing a set of top signal routing lines in a first metal layer above the second tier and connecting the set of top signal routing lines to the first and the second transistor structure from above; and processing at least one bottom signal routing line in a second metal layer below the first tier and connecting the bottom signal routing line to the first transistor structure from below.

The method of the third aspect achieves the same advantages as the CFET cell of the first aspect, and may be extended by respective implementations as described above for the CFET cell of the first aspect.

Notably, the steps of the method of the third aspect do not have to be performed, necessarily, in the order in which they are described above. For instance, the bottom signal routing line(s) can be processed prior to the set of top signal routing lines. However, it is also possible to process the top signal routing lines first especially when the bottom signal routing line is processed from the bottom side.

In an implementation, the bottom signal routing line is processed by etching a trench in a dielectric layer of the CFET cell and subsequently filling the bottom of the trench with the second metal layer.

For instance, the bottom signal routing line can be processed in this way after an active patterning and an STI (shallow trench isolation) planarization of the CFET cell.

In an implementation, to fill the bottom of the trench with the second metal layer, the second metal layer is deposited in the trench and subsequently partially recessed in order to confine the second metal layer to the bottom of the trench below the first tier.

In an implementation, the method further comprises the steps of: processing one or more metal zero (Mo) layer contacts of the first transistor structure, wherein each Mo layer contact is connected to a source or a drain of the first transistor structure; and connecting the bottom signal routing line to the Mo layer contacts.

In an implementation, the method further comprises the step of: processing a first power rail below the first tier and connecting the first power rail to the first transistor structure from below.

In an implementation, the method further comprises the step of: processing a second power rail in a third metal layer to a first side of the second transistor structure and connecting the second power rail to the second transistor structure.

### BRIEF DESCRIPTION OF THE DRAWINGS

The above described aspects and implementations are explained in the following description of embodiments with respect to the enclosed drawings:
- FIG. 1: shows a CFET cell according to this disclosure in a side view;
- FIG. 2: shows a first transistor structure of a CFET cell according to this disclosure in a top view;
- FIGS. 3A-B: show a CFET cell according to this disclosure in a perspective view;
- FIG. 4: shows an equivalent circuit diagram of a CFET cell according to this disclosure;
- FIG. 5: shows a CFET cell according to this disclosure in a side view;
- FIG. 6: shows a device comprising two CFET cells according to this disclosure;
- FIGS. 7A-D: show steps of a method of fabricating a CFET cell according to this disclosure; and
- FIG. 8: shows steps of a method of fabricating a CFET cell according to this disclosure.

### DETAILED DESCRIPTION OF EMBODIMENTS

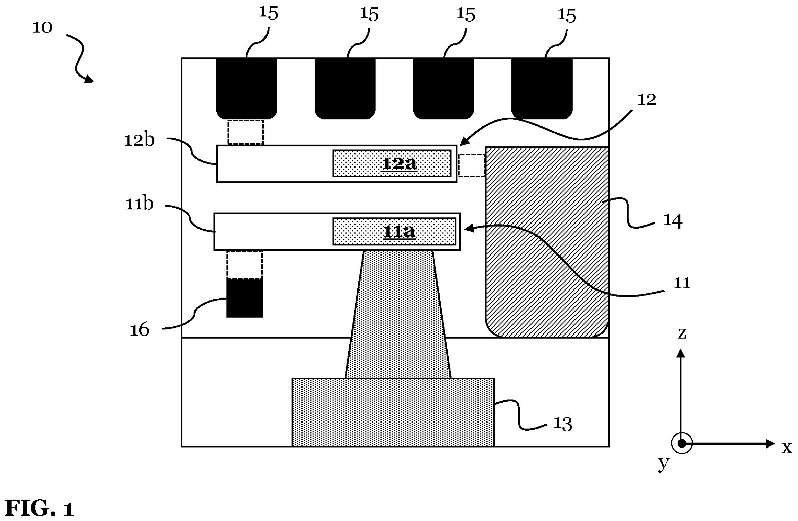

FIG. 1 shows a CFET cell 10 according to this disclosure in a side view. The CFET cell 10 comprises: a first transistor structure 11 arranged in a first tier of the CFET cell 10; a second transistor structure 12 arranged in a second tier of the CFET cell 10 above the first tier; a set of top signal routing lines 15 formed in a first metal layer above the second tier and connected to the first and the second transistor structure 11, 12 from above; and at least one bottom signal routing line 16 formed in a second metal layer below the first tier and connected to the first transistor structure 11 from below.

Hereby, above/below corresponds to a ("vertical") z-direction in FIG. 1 which may correspond to a stacking/fabrication direction of the CFET cell 10. Notably, FIG. 1 does not show a cross-section of the CFET cell 10, so that the second transistor structure 12 is not necessarily directly above the first transistor structure 11, but in fact may be offset from or shifted with respect to (in this case into the plane of FIG. 1) the first transistor structure 11. The CFET cell 10 may comprise further transistor structures or other elements/components, which are not shown in FIG. 1.

The CFET cell 10 shown in FIG. 1 may be a unit cell of a CFET device, wherein unit cell means that the CFET cell 10 could be repeated one or more times in the CFET device. For instance, multiple CFET cells 10 could be arranged side by side, or one above the other, or both. FIG. 1 shows particularly a side view of the CFET cell 10.

The first transistor structure 11 and the second transistor structure 12 can each comprise one or more channels 11a, 12a which in FIG.1 extend in a y-direction, perpendicular to the x-z plane. For instance, each of the one or more channels 11a, 12a can form a channel stack. The channels 11a, 12a can be silicon (Si) channels.

The first transistor structure 11 can comprise one or more metal zero (Mo) layer contacts 11b. The Mo layer contact(s) 11b can be connected to a source/drain of the first transistor structure 11 and/or can merge into the source/drain of the first transistor structure 11.

The bottom signal routing line 16 can be connected to the Mo layer contact 11b from the bottom side. This connection can be established by vertical contact sections, illustrated by a dashed box in FIG. 1. In this way, the bottom signal routing line 16 can be connected to a source and/or drain of the first transistor structure 11.

Likewise the second transistor structure 12 can comprise one or more Mo layer contacts 12b. The Mo layer contact(s) 12b can be connected to a source/drain of the second transistor structure 12 and/or can merge into the source/drain of the second transistor structure 12.

The respective source/drain of the first transistor structure 11 and the second transistor structure 12 can wrap around the respective channel(s) 11a, 12a of the transistor structures 11, 12.

At least one of the top signal routing lines 15 of the set of top signal routing lines can be connected by a respective contact structure to the first transistor structure 11 and/or the second transistor structure 12. For instance, these contact structures can be formed by high aspect-ratio vias.

A possible connection of a top signal routing line 15 to the Mo zero layer contacts 12b of the second transistor structure 12 is illustrated by a dashed box in FIG. 1. The set of top signal routing lines 15 may further be connected by a respective contact structure to a gate of the first transistor structure 11 and/or to a gate of the second transistor structure 12.

The bottom signal routing line 16 can be a line structure which extends in a y-direction, perpendicular to an extension direction of the Mo layer contacts 11b, 12b.

The CFET cell 10 can comprise one or a plurality of bottom signal routing lines 16. For instance, a bottom signal routing line 16 could be arranged on each side of the channel stack, in particular, if none of the sides is blocked by a power rail 14.

The CFET cell 10 can further comprise a first power rail 13 arranged below the first tier and connected to the first transistor structure 11 from below. A possible contact between the first power rail 13 and the first transistor structure 11 is illustrated by a trapezoidal structure FIG. 1, but the first power rail 13 could also be connected directly to the first transistor structure 11 from below. The first power rail 13 may be a back-side power rail, and may be connected to the first transistor structure 11 by a back-side contact.

For example, the at least one bottom signal routing line 16 can be arranged above the first power rail 13 and below the first transistor structure 11, i.e., in-between the first power rail 13 and the first transistor structure 11. The bottom signal routing line 16 can be arranged in a space next to the back-side contact of the first power rail 13 which is not occupied by any other structures.

The CFET cell 10 may comprise a second power rail 14 formed in a third metal layer and connected to the second transistor structure 12b from a first side (the right side in FIG. 1). A possible contact between the second power rail 14 and the second transistor structure 12 is illustrated by a dashed box, but the second power rail 14 could also be connected directly to the second transistor structure 12.

For example, a part of the second power rail can be arranged in the second tier to the first side of the second transistor structure; and/or a part of the second power rail is arranged in the first tier to the first side of the first transistor structure.

Alternatively to the example shown in FIG. 1, different arrangements of the first and second power rail 13, 14 are possible. For instance, both power rails 13, 14 can may be arranged below the first tier and can both be connected to the first respectively second transistor structure 11, 12 from below.

The first power rail 13 may be configured to supply VDD (a supply voltage), i.e., is a VDD rail, and the second power rail 14 may be configured to supply VSS (a ground voltage or negative voltage), i.e., is a VSS rail. For instance, VDD and VSS could also be swapped.

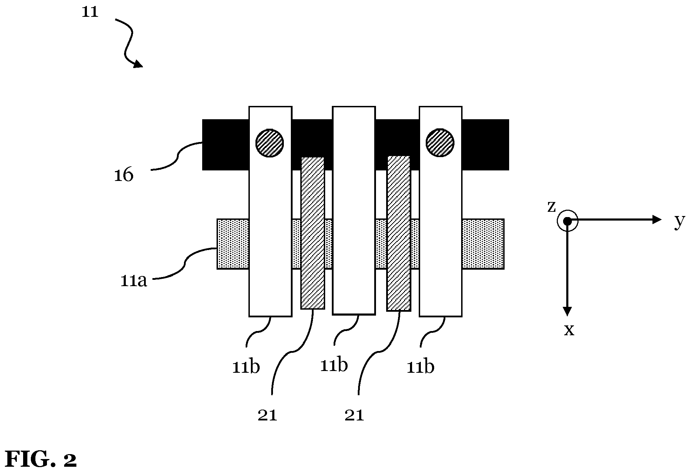

FIG. 2 shows the first transistor structure 11 of the CFET cell 10 according to this disclosure in a top view. In particular, FIG. 2 shows a possible arrangement of the first transistor structure 11 of FIG. 1 in the x- and y-direction, as indicated by the Cartesian coordinate system.

The first transistor structure 11 in FIG. 1 comprises gate structures 21 which are arranged along the direction of the channel (e.g., alternating with source/drain structures). For instance, the gates 21 can be wrapped around the channel(s) 11a.

The Mo contact structures 11b extend perpendicular to the channel direction and can be connected to and/or merge with respective source or drain (structures) of the first transistor structure 11.

FIG. 2 further shows the bottom signal routing line 16 which is arranged below (in z-direction) the Mo contact structures 21 and is connected to two of the Mo contact structures 21, as indicated by the two shaded circles.

For example, the bottom signal routing line 16 can be a one-dimensional line structure. In particular, this means that it extends along one spatial direction (here: the y-direction) and is spatially confined in all other spatial directions. The bottom signal routing line 16 can thus be configured to route signals along this one spatial direction.

In particular, the bottom signal routing line 16 can extend along a direction which is parallel to the channel direction and perpendicular to the gates 21.

The Mo contact structures 11b can also be one-dimensional structures which are arranged perpendicular to the bottom signal routing structure 16 and/or the channel(s) 11a.

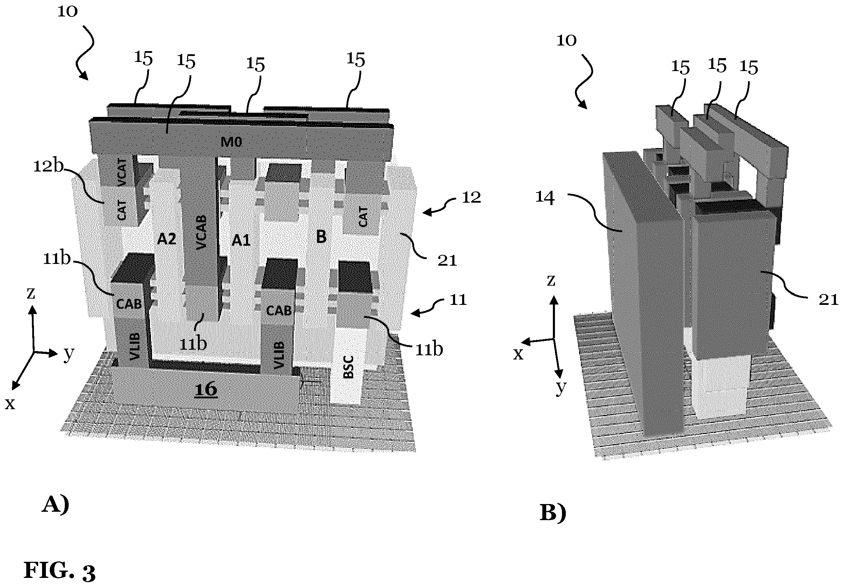

FIGS. 3A and 3B show a CFET cell 10 according to this disclosure in different perspective views (its extension in x-, y- and z-direction, as indicated by the Cartesian coordinate systems in FIGS. 3A and 3B). In particular, FIG. 3A and 3B show the same CFET cell 10. The CFET cell 10 of FIGS. 3A-B may build on or may be the CFET cell shown in FIG. 1 and/or FIG. 2.

The CFET cell 10 shown in FIG. 3A and 3B comprises a number of gates 21, referred to as A2, A1 and B as well as a number of Mo layer contacts 11b, 12b of the first and second transistor structure 11, 12, referred to as CAB (contact active bottom) respectively CAT (contact active top). For instance, CAB and/or CAT can be one dimensional structures. CAT and CAB can also be referred to as MoAT and MoAB, respectively.

As shown in FIG. 3A and 3B, one or more top signal routing lines 15 can be connected to a respective Mo layer contact 11b, 12b of the first and second transistor structure 11,12. These connection can be established via vertical contact structures, e.g. vias, referred to as VCAT and VCAB. The top signal routing lines 15 can be formed in a metal intermediate (Mint) layer.

Likewise, the bottom signal routing line 16 can be connected to the Mo layer contact CAB via vertical contact structures, e.g. vias, referred to as VLIB. The bottom signal routing line 16 can form a (one-dimensional) horizontal local interconnect level (HLI).

Due to this CFET cell 10 design, CAT/CAB can become purely one-dimensional structures (all horizontal routing can be removed). As such, all signal routing in the CFET cell 10 can be one-dimensional. Such one-dimensional metal levels are much easier to print and to process than 2D metal levels. Hence, this approach makes the routing in the CFET cell 10 more scalable and easier to manufacture. In particular, the one-dimensionality of the bottom signal routing line allows for narrower lithography pitches when manufacturing the CFET cell 10.

The CFET cell 10 can further comprise a back-side contact (BSC) which connects the first transistor structure 11 to the first power rail (not shown).

FIG. 3B shows the second power rail 14 which is arranged on the first side of the transistor structures 11, 12. In the perspective of FIG. 3A this second power rail 14 is arranged "behind" the visible structures.

For instance, the bottom signal routing line 16 can provide horizontal routability to the bottom device (the first transistor structure 11) polarity. The top device (the second transistor structure 12) polarity can be brought up to Mint, i.e. connected to the set of top signal routing lines 15, to achieve horizontal routability. Hence, with this 3-levels interconnect design, all horizontal routing can be removed from CAT/CAB which can become purely vertical (1D).

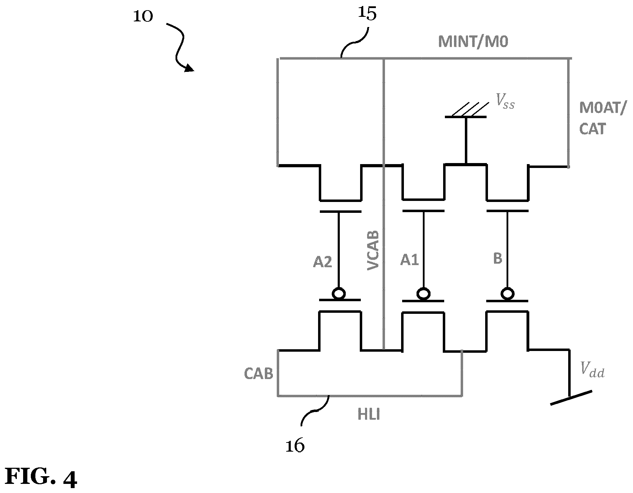

FIG. 4 shows an equivalent circuit diagram of the CFET cell 10 shown in FIGS. 3A-B.

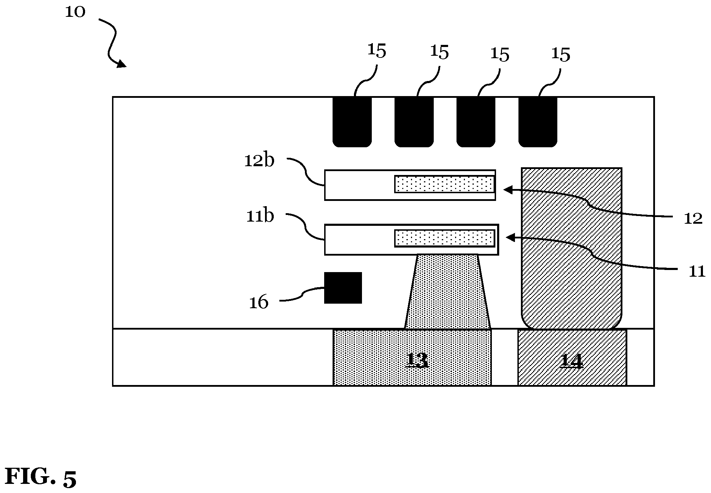

FIG. 5 shows a CFET cell 10 according to this disclosure in a side view. In the example shown in FIG. 5, the second power rail 14 extends vertically to the bottom side of the CFET cell 10.

The top signal routing lines 15 can be arranged side by side. A part of the second power rail can be arranged to the first side of the set of top signal routing lines 15.

For instance, if the second power rail 14 extends to the bottom side of the CFET cell 10, as shown in FIG. 5, an additional top signal routing line 15 could be formed in the first metal layer above the second tier and to the first side of the set of top signal routing lines 15, and could be connected to the first and/or the second transistor structure 11, 12 from above.

For example, the second power rail 14 has a width that is equal to or larger than two times a critical dimension of the first metal layer.

In a further example, the top signal routing lines 15 of the set of top signal routing lines and a half of the second power rail 14 span together a width of the CFET cell 10 that corresponds to a track height of a 3.5T or 4T CFET cell 10.

In an alternative design (not shown), the second power rail 14 could also be contacted via one or more top signal routing line(s) 15 (not shown).

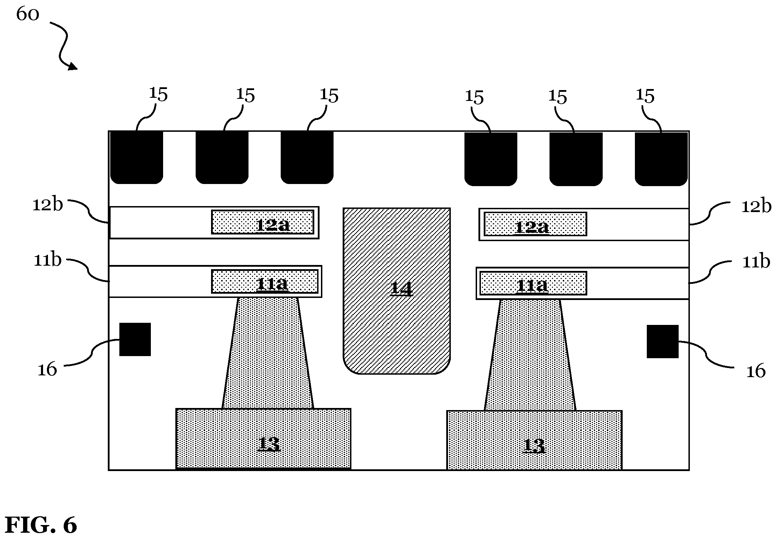

FIG. 6 shows a CFET device 60 according to this disclosure. The CFET device 60 is particularly shown with two CFET cells 10 and in a side view. The two CFET cells 10 are arranged side by side.

In the device 60 shown in FIG. 6, the second power rail 14 is common to both of the two CFET cells 10, i.e., it is the same power rail for each CFET cell 10. The second power rail 14 is arranged between the transistor structures 11, 12 of one of the two CFET cells 10 and the transistor structures 11, 12 of the other one of the two CFET cells 10.

Thus, the center of the CFET device 60 between the two CFET cells 10 can be optimized for power-delivery. Each CFET cell 10 can have at least three top signal routing lines 15. The second power rail 14 may particularly have a width (e.g., in x-direction) that is equal to or larger than two times a critical dimension of the first metal layer, in which the signal routing lines 15 are formed, for instance the Mint layer. The second power rail 14 may further be configured as shown in FIG. 5, i.e., reaching to the bottom of the CFET cell 10.

Due to each bottom signal routing lines 16 being arranged below a respective first transistor structures 11, the size of the CFET device 60 can be reduced, in particular compared to a CFET device 60 with a side-routing architecture.

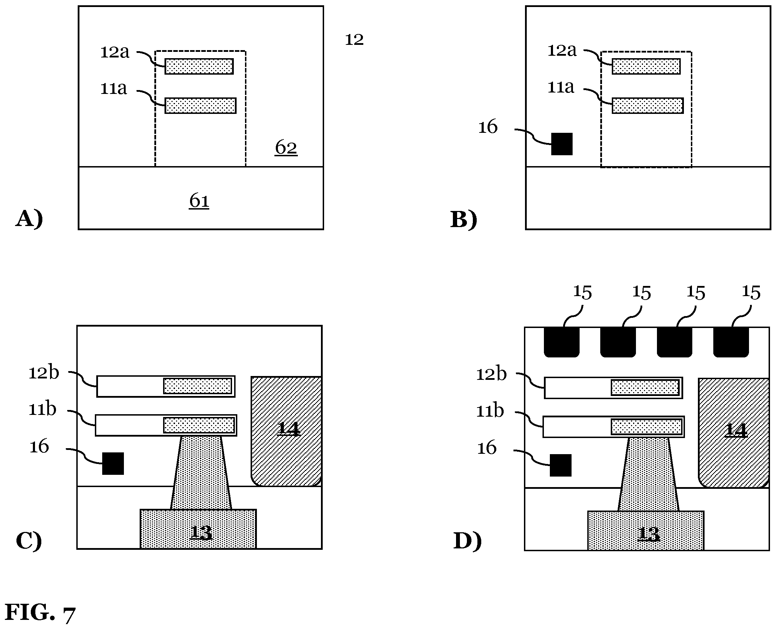

FIGS. 7A-D show steps of a method of fabricating a CFET cell according to this disclosure.

In a first step, shown in FIG. 7A, at least a part of the first transistor structure 11 is formed in a first tier of the CFET cell 10, and at least a part of the second transistor structure 12 is formed in a second tier of the CFET cell 10 above the first tier.

In particular, the channel(s) 11a, 12a of the first and the second transistor structure 11, 12 are formed in this first step. For instance, the first step comprises active (channel) patterning of the first and the second transistor structure 11,12.

The channel(s) 11a, 12a can be formed on top of a silicon substrate 61. The channel(s) 11a, 12a can be surrounded by a dielectric layer 62, e.g. a metal oxide (MOL).

In a second step, shown in FIG. 7B, the at least one bottom signal routing line 16 is formed in the second metal layer below the first tier.

For instance, the bottom signal routing line 16 can be formed after active patterning of the channels 11a, 12a and STI planarization.

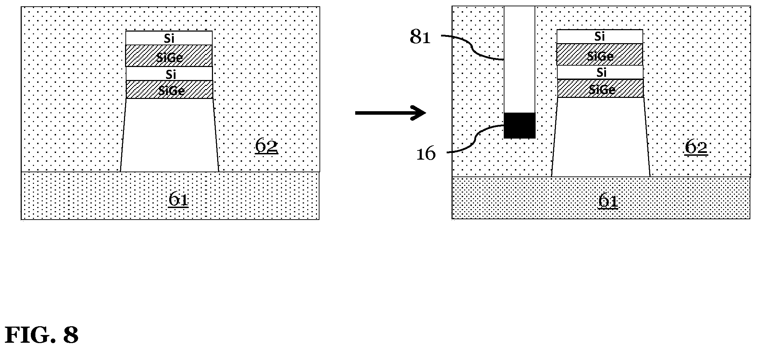

An example of how the bottom signal routing line 16 can be processed is shown in FIG. 8. For instance, the bottom signal routing line 16 is processed by etching a trench 81 in the dielectric layer 62 of the CFET cell 10 (next to the channels), and subsequently filling the bottom of the trench 81 with the second metal layer material, e.g. by means of a suitable liquid metal fill process. After deposition of the second metal layer in the trench 81, this layer can be partially recessed, e.g. by means of an etching process, in order to confine the second metal layer to the bottom of the trench 81 and below the first tier. This can be carried out for each bottom signal routing line 16 of the CFET cell 10.

The bottom signal routing line 16 could also be formed from the bottom, e.g., by etching and filling the trench 81 from the bottom.

In this way, the signal routing line 16 can form a buried horizontal interconnect (HLI) level which can be arranged next to a back-side contact and/or a silicon base of the transistor structures 11, 12.

In a subsequent step, shown in FIG. 7C, further structures of the CFET cell can be processed. For instance, the Mo layer contacts 11b, 12b of the first and the second transistor structure 11, 12 can be formed after the processing of the bottom signal routing line 16. Furthermore, the gate(s) and source/drain(s) of the CFET cell can be formed after the processing of the bottom signal routing line 16. Each Mo layer contact 11b, 12b can be connected to a source or a drain of the first respectively second transistor structure 11, 12.

Furthermore, vertical connections can be formed to connect the bottom signal routing line 16 to the first transistor structure 11, in particular to the Mo layer contacts 11b of the first transistor structure 11.

Further, CFET BSPDN (backside power delivery) processing can be carried out. For example, the first power rail 13 can be processed below the first tier and can be connected to the first transistor structure 11 from below, e.g. via a back side contact structure. In addition, the second power rail 14 can be processed in a third metal layer, e.g., to a first side of the second transistor structure 12 and can be connected to the second transistor structure 12 from the first side. However, alternative arrangements of the first and second power rail 13, 14 are also possible (e.g., both power rails 13, 14 can be processed below the first tier).

In a final step, shown in FIG. 7D, the set of top signal routing lines 15 are processed in a first metal layer above the second tier.

The top signal routing lines 15 can be connected to the first and the second transistor structure from above in a subsequent step (not shown), e.g., by forming vertical connecting structures such as vias.

Notably, the steps of the method of fabricating the CFET cell 10 do not have to be performed, necessarily, in the order described above and/or shown in FIGS. 7A-D.

In the claims as well as in the description of this disclosure, the word "comprising" does not exclude other elements or steps and the indefinite article "a" or "an" does not exclude a plurality. A single element may fulfill the functions of several entities or items recited in the claims. The mere fact that certain measures are recited in the mutual different dependent claims does not indicate that a combination of these measures cannot be used in an advantageous implementation.

## Claims

1. A complementary field effect transistor, CFET, cell (10), comprising:
a first transistor structure (11) arranged in a first tier of the CFET cell (10);
a second transistor structure (12) arranged in a second tier of the CFET cell (10) above the first tier;
a set of top signal routing lines (15) formed in a first metal layer above the second tier and connected to the first and the second transistor structure (11, 12) from above; and
at least one bottom signal routing line (16) formed in a second metal layer below the first tier and connected to the first transistor structure (11) from below.

2. The CFET cell 10 of claim 1,
wherein the bottom signal routing line (16) is a one-dimensional line structure, and/or is configured to route signals along one spatial direction.

3. The CFET cell 10 of claim 1 or 2,
wherein the bottom signal routing line (16) extends along a direction which is perpendicular to a gate of the first transistor structure (11) and/or to a gate of the second transistor structure (12).

4. The CFET cell 10 of any one of the preceding claims,
wherein the bottom signal routing line (16) is connected to one or more metal zero, Mo, layer contacts (11b) of the first transistor structure (11);
wherein each Mo layer contact (11b) is connected to a source or a drain of the first transistor structure (11).

5. The CFET cell 10 of any one of the preceding claims, further comprising:
a first power rail (13) arranged below the first tier and connected to the first transistor structure (11) from below.

6. The CFET cell 10 of any one of the preceding claims, further comprising:
a second power rail (14) formed in a third metal layer and connected to the second transistor structure (12) from a first side.

7. The CFET cell 10 of claim 6,
wherein the second power rail (14) extends vertically to a bottom side or to a top side of the CFET cell (10).

8. The CFET cell (10) of claim 6 or 7,
wherein the top signal routing lines (15) of the set of top signal routing lines are arranged side by side, and a part of the second power rail (14) is arranged to the first side of the set of top signal routing lines (15).

9. A device (60) comprising two CFET cells (10) of any one of the preceding claims,
wherein the two CFET cells (10) are arranged side by side.

10. A method of fabricating a complementary field effect transistor, CFET, cell (10), comprising the steps of:
forming a first transistor structure (11) in a first tier of the CFET cell (10);
forming a second transistor structure (12) in a second tier of the CFET cell (10) above the first tier;
processing a set of top signal routing lines (15) in a first metal layer above the second tier and connecting the set of top signal routing lines (15) to the first and the second transistor structure (11, 12) from above; and
processing at least one bottom signal routing line (15) in a second metal layer below the first tier and connecting the bottom signal routing line (16) to the first transistor structure (11) from below.

11. The method of claim 10,
wherein the bottom signal routing line (16) is processed by etching a trench (81) in a dielectric layer (62) of the CFET cell (10) and subsequently filling the bottom of the trench (81) with the second metal layer.

12. The method of claim 11,
wherein, to fill the bottom of the trench (81) with the second metal layer, the second metal layer is deposited in the trench (81) and subsequently partially recessed in order to confine the second metal layer to the bottom of the trench (81) below the first tier.

13. The method of any one of claims 10 to 12, further comprising the steps of:
processing one or more metal zero, Mo, layer contacts (11b) of the first transistor structure (11), wherein each Mo layer contact (11b) is connected to a source or a drain of the first transistor structure (11); and
connecting the bottom signal routing line (16) to the Mo layer contacts (11b).

14. The method of any one of claims 10 to 13, further comprising the step of:
processing a first power rail (13) below the first tier and connecting the first power rail (13) to the first transistor structure (11) from below.

15. The method of any one of claims 11 to 14, further comprising the step of:
processing a second power rail (14) in a third metal layer to a first side of the second transistor structure (12) and connecting the second power rail (14) to the second transistor structure (12).
